(19)

**Europäisches Patentamt**
**European Patent Office**
**Office européen des brevets**

(11) **EP 4 575 541 A1**

(12) **EUROPEAN PATENT APPLICATION**

(43) Date of publication:
**25.06.2025 Bulletin 2025/26**

(21) Application number: **23218953.0**

(22) Date of filing: **21.12.2023**

(51) International Patent Classification (IPC):
**G01R 33/44** (2006.01)   **G01R 33/561** (2006.01)
**G01R 33/50** (2006.01)   **G01R 33/54** (2006.01)
**G01R 33/56** (2006.01)   **G01R 33/563** (2006.01)

(52) Cooperative Patent Classification (CPC):
**G01R 33/5614; G01R 33/443; G01R 33/5616;**
G01R 33/546; G01R 33/5602; G01R 33/5608;
G01R 33/56341

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventors:
- **MEINEKE, Jan Jakob**
  **Eindhoven (NL)**
- **KATSCHER, Ulrich Wolfgang**
  **Eindhoven (NL)**
- **KEUPP, Jochen**
  **5656AG Eindhoven (NL)**

(74) Representative: **Philips Intellectual Property & Standards**
**High Tech Campus 52**
**5656 AG Eindhoven (NL)**

(54) **MAGNETIC RESONANCE IMAGING WITH MULTIPLE CONTRASTS**

(57)    Methods and systems for magnetic resonance imaging are presented. According to an aspect of the invention a method is disclosed, comprising: obtaining magnetic resonance imaging data by subjecting the patient to a steady-state imaging sequence that samples multiple coherence pathways, wherein two or more echo signals are generated in each interval between successive radiofrequency pulses; deriving susceptibility information from the magnetic resonance imaging data; outputting to a display an image based on the susceptibility information. The invention further provides a time-efficient single scan method from which various image contrasts can be derived, such as for example susceptibility with a combination of any of the T2 weighted image, diffusion weighted image and conductivity, all representing various biomarkers of which combination can lead to distinguishing different types of diseases and/or to distinguishing stages in evolution of a specific disease type (e.g., cancer).

Fig. 3

**Description**

**FIELD OF THE INVENTION**

The invention relates to the field of magnetic resonance imaging. It concerns methods and systems for magnetic resonance imaging of an object.

**BACKGROUND OF THE INVENTION**

Image-forming magnetic resonance methods that utilize the interaction between magnetic fields and nuclear spins in order to form two-dimensional or three-dimensional images are widely used nowadays, notably in the field of medical diagnostics, because for soft tissue imaging they are superior to other imaging methods in many respects, e.g., do not require ionizing radiation and are usually not invasive.

Quantitative magnetic resonance imaging is one of the imaging techniques that potentially could be used for non-invasive diagnosis, in particular Electrical Properties Tomography (EPT). An extensive review of EPT is to be found in Leijsen R., et al., "Electrical Properties Tomography: A Methodological Review", Diagnostics 2021, 11, 176, https://doi.org/10.3390/diagnostics11020176, which is hereby incorporated by reference in its entirety.

WO2020/254571 A1 discloses a method of Magnetic Resonance Imaging (MRI) of an object placed in an examination volume of a Magnetic Resonance (MR) device, wherein the method comprises the steps of: subjecting the object to a multi-echo steady-state imaging sequence comprising radiofrequency (RF) pulses and switched magnetic field gradients, wherein two or more echo signals are generated in each interval between successive RF pulses, wherein the imaging sequence comprises diffusion weighting magnetic field gradients; acquiring the echo signals in a number of repetitions of the imaging sequence; deriving at least one magnitude image and at least one phase map from the acquired echo signals, which phase map represents the spatial RF field distribution induced by the RF pulses in the object; and reconstructing an electric conductivity map from the MR image and from the phase map, wherein boundaries between normal and suspicious tissues are derived on the basis of diffusion weighting in the at least one magnitude image for reconstructing the electric conductivity map from the phase map. The method enables MR signal acquisition in a single scan by providing the information necessary for EPT, namely a phase map as well as tissue boundaries for tumor delineation, thereby the MR image acquisition technique having a tumor detection sensitivity comparable to dynamic contrast enhanced MR imaging (DCE). MR device and computer program to be run on an MR device are also disclosed, which computer program comprises instructions for carrying out the MR imaging method listed hereinbefore. WO2020/254571 A1 is hereby incorporated by reference in its entirety.

Improving MR imaging methods for detection, delineation and specification of tumor is a continuous effort in the continuum of care.

SUMMARY OF THE INVENTION

It is an object of the invention to provide methods and systems for MR signal acquisition in a single scan from which additional biomarkers can be derived, contributing to improved sensitivity and specificity in diagnosis of tumors, being that prior or post treatment. According to an aspect of the invention a method is disclosed, comprising:

obtaining magnetic resonance imaging data by subjecting an object, preferably a portion of the body of a subject, to a steady-state imaging sequence that samples multiple coherence pathways, wherein two or more echo signals are generated in each interval between successive RF pulses;
deriving susceptibility information from the magnetic resonance imaging data;
outputting to a display an image based on the susceptibility information.

In an embodiment, the method may further comprise: deriving conductivity information from the magnetic resonance imaging data; outputting to the display an image based on the conductivity information.

In an embodiment, the method may further comprise: deriving T2 weighted information from the magnetic resonance imaging data; outputting to the display an image based on the T2 weighted information.

In an embodiment, the steady-state imaging sequence comprises diffusion sensitizing gradients, and the method may further comprise: deriving diffusion weighted information from the magnetic resonance imaging data; outputting to the display an image based on the diffusion weighted information.

The invention provides various image contrasts that can be derived time-efficiently from a single scan, such as for example susceptibility with a combination of any of the T2 weighted image, diffusion weighted image and conductivity, all representing various biomarkers of which combination can lead to distinguishing different types of diseases and/or evolution of a specific type of disease (e.g., cancer). In oncology, for example, well co-localized imaging information is highly desirable, such as T2 relaxation supporting localization of tumor tissue, diffusion being indicative of tumor microstructure/cellularity, susceptibility being indicative of tumor hemorrhage or micro-hemorrhage and electrical properties such as conductivity being indicative of tumor malignancy via cell membrane effects and sodium content.

In any of the embodiments of the method, tissue boundaries may be derived based on signal magnitude of one of the multiple echoes. In a preferred embodiment the first echo is used for tissue boundary detection, because the echo at $TE^+$ typically shows a higher Signal to Noise Ratio (SNR) than the other echo(s).

In an embodiment of the method, deriving tissue boundaries involves a segmentation of a magnitude image. In alternative embodiment the boundaries between normal and suspicious tissues may be derived based on diffusion weighting in the at least one magnitude image.

In some of the embodiments the segmentation of magnitude image may be based on deep learning or machine learning.

In some embodiments deriving tissue boundaries may be a prerequisite of deriving susceptibility and/or conductivity information.

In some embodiments the multi-echo steady-state imaging sequence may be a double-echo steady-state sequence.

In some embodiments deriving susceptibility information is preceded by providing segmentation of the anatomy of the imaged portion of the body into one or more anatomical regions. The portion of the body for segmentation of the anatomy may be selectable by a user through a user interface, e.g., touch screen, mouse, through a predefined menu, tab.

In some of the embodiments outputting the image may comprise replacing each of the segmented one or more anatomical regions with corresponding susceptibility information. In some of the embodiments this holds also for conductivity information.

In some of the embodiments outputting the image comprises overlaying susceptibility information on the respective one or more anatomical regions on an anatomic image, wherein the anatomic image is preferably the magnetic resonance image used for providing the image segmentation.

According to a further aspect of the invention, a system for magnetic resonance imaging is disclosed, comprising a processor configured to perform any of the method embodiments according to the invention. In some embodiments the system may comprise: a magnetic resonance imaging system for providing the magnetic resonance imaging data and a screen display configured to display the one or more images according to the invention.

In a further aspect of the invention a computer program comprising machine executable instructions is disclosed, wherein execution of the machine executable instructions causes a computational system to perform any of the method embodiments according to the invention.

Features described above with respect to method embodiments are applicable and are contemplated also for corresponding system embodiments, with similar benefits.

This Summary is provided to introduce a selection of concepts in a simplified form that are further described below in the Detailed Description. This Summary is not intended to identify key features or essential features of the claimed subject matter, nor is it intended to limit the scope of the claimed subject matter. A more extensive presentation of features, details, utilities, and advantages of the system, as defined in the claims, is provided in the following written description of various embodiments of the disclosure and illustrated in the accompanying drawings.

**BRIEF DESCRIPTION OF THE DRAWINGS**

The enclosed drawings disclose preferred embodiments of the present invention. It should be understood, however, that the drawings are designed for the purpose of illustration only and not as a definition of the limits of the invention. In the drawings:

Fig. 1 shows a system for carrying out the method according to the invention;
Fig. 2 illustrates a method of magnetic resonance imaging according to the invention;
Fig. 3 shows an exemplary computation flowchart according to the invention;
Fig. 4 illustrates exemplarily the four different contrast images obtainable from a single scan, according to the invention;
Fig. 5 shows susceptibility and conductivity images of the same phantom used for the example in Fig. 4, but for which the data was acquired with respective conventional scanning sequences.

**DETAILED DESCRIPTION OF THE EMBODIMENTS**

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

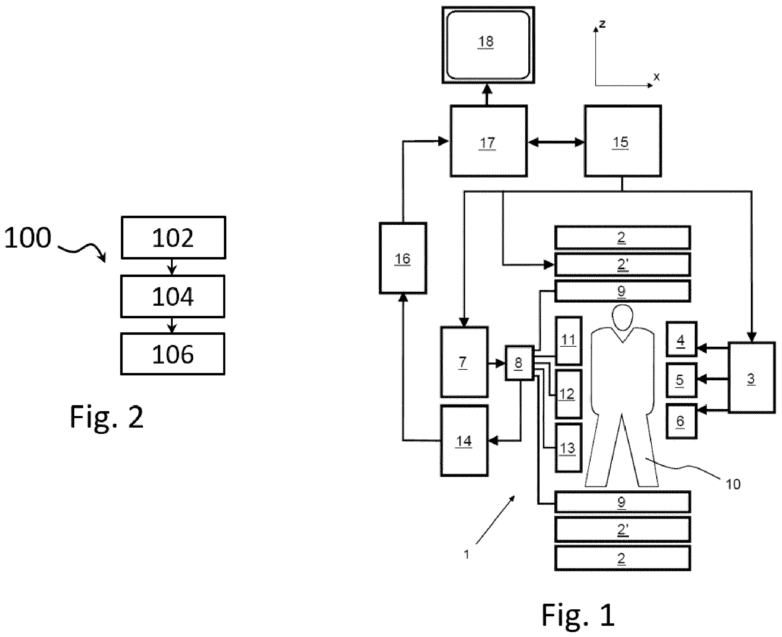

With reference to Fig. 1, an MR system 1 is shown. The system comprises superconducting or resistive main magnet coils 2, 2' such that a substantially uniform, temporally constant main magnetic field is created along a z-axis through an examination volume.

A magnetic resonance generation and manipulation system applies a series of RF pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF transmitter 7 transmits RF pulses or pulse packets, via a send/receive switch 8, to a whole-body volume RF coil 9 to transmit RF pulses into the examination volume. A typical MR imaging sequence is composed of a packet of RF pulse segments of short duration, which taken together with each other and any applied magnetic field gradients achieve a selected manipulation of nuclear magnetic resonance. The RF pulses are used to saturate, excite resonance, invert magnetization, refocus resonance, or manipulate resonance and select a portion of a body 10 positioned in the examination volume. The MR signals are also picked up by the whole-body volume RF coil 9 and/or by the array RF coils 11, 12, 13.

For generation of MR images of limited regions of the body 10, a set of local array RF coils 11, 12, 13 are placed contiguous to the region selected for imaging. The array coils 11, 12, 13 can be used to receive MR signals induced by body-coil RF transmissions.

The resultant MR signals are picked up by the whole-body volume RF coil 9 and/or by the array RF coils 11, 12, 13 and are demodulated by a receiver 14, preferably including a preamplifier (not shown). The receiver 14 is connected to the RF coils 9, 11, 12 and 13 via send/receive switch 8.

A host computer 15 controls the gradient pulse amplifier 3 and the transmitter 7 to generate any of a plurality of MR imaging sequences, such as Double-Echo Steady-State (DESS) imaging sequence, Diffusion Weighted Double-Echo Steady-State (DW-DESS) imaging sequence or the like. For the selected sequence, the receiver 14 receives a single or a plurality of MR data lines in rapid succession following each RF excitation pulse. A data acquisition system 16 performs analog-to-digital conversion of the received signals and converts each MR data line to a digital format suitable for further processing. The data acquisition system 16 may be a separate computer that is specialized in acquisition of raw image data, such as implemented in modern MR systems.

Eventually, the digital raw image data is reconstructed into an image representation by a reconstruction processor 17, which applies a Fourier transform or other appropriate reconstruction algorithms, such as SENSE, SMASH, or GRAPPA. The MR image may represent a planar slice through the patient, an array of parallel planar slices, a three-dimensional volume, or the like. The image is then stored in an image memory where it may be accessed for converting slices, projections, or other portions of the image representation into appropriate format for visualization, for example via a video monitor or screen display 18, which provides a man-readable display of the resultant MR image.

With continuing reference to Fig. 1 and with further reference to Fig. 2 an embodiment of the method according to the invention is explained in the following.

A valuable advantage of MRI is given by the multitude of image contrasts available, reflecting different biomarkers for diagnosis. Examples of biomarkers may be obtained by diffusion weighted imaging (DWI), by Quantitative Susceptibility Mapping (QSM) and/or by Electrical Properties Tomography (EPT), providing different contrasts, which are usually obtained by employing separate MR sequences.

According to an aspect of the invention, a method 100 of magnetic resonance imaging is provided, illustrated in Fig. 2. In step 102 magnetic resonance imaging data is provided by an MR system 1 through subjecting the body 10 or a portion of the body to a steady-state imaging sequence that samples multiple coherence pathways (MESS), which for example may be a DESS sequence, Triple-Echo Steady-State (TESS) sequence, wherein two or more echo signals are generated in each interval between successive RF pulses. In general, steady-state imaging sequences are based on a gradient echo imaging sequence with a short repetition time. Steady-state sequences include transverse coherences from overlapping multi-order spin echoes and stimulated echoes. This is usually accomplished by refocusing the phase-encoding gradient in each repetition interval, in order to keep the phase integral (or gradient moment) constant. Fully balanced steady state imaging sequences achieve a phase of zero by refocusing all imaging gradients. Both the phase map and the tissue contrast can be derived from a single scan by using one of the MESS sequences for acquiring the magnetic resonance imaging data.

In step 104 susceptibility information is derived from the magnetic resonance imaging data by using a processor or a computing system. The processor may be integrated in the system 1 either separate or within any of the processing sub-systems 15 and 17.

Quantitative susceptibility and conductivity may be obtained by using the phase behavior of the magnetic resonance imaging data acquired with the MESS sequence, e.g., DESS sequence. The phase behavior depends on the position of the spoiler gradient required for this sequence. For instance, the phase maps $\varphi^+$ and $\varphi^-$ of the two echoes of a DESS sequence with a spoiler gradient located symmetrically between the two echoes yields:

$$\varphi_1 = 0.5\,(\varphi^+ + \varphi^-) \qquad\qquad [1]$$

$$\Delta B_0 = 0.5\,\gamma^{-1}\,(\varphi^+ - \varphi^-)\,/\,\mathrm{TE} \qquad\qquad [2]$$

wherein TE is the echo time, $\varphi_1$ is the phase originating from $B_1$, and $\Delta B_0$ is the $B_0$ inhomogeneity (or inhomogeneity field map) induced by the magnetic susceptibility and other sources. Equations [1] and [2] can be used as input to calculate susceptibility $\chi$ and conductivity $\sigma$, respectively.

In a second example, the spoiler gradient of a DESS sequence is located after the second echo. In this case, the phase maps of two different repetition times $TR_a$ and $TR_b$ are required:

$$\varphi_1 = 0.5(\varphi_a^+ + \varphi_a^-) - 0.5\frac{\varphi_b^- - \varphi_a^-}{TR_b - TR_a}(TR_a - TE) \qquad\qquad [3]$$

$$\Delta B_0 = 0.5\gamma^{-1}(\varphi_a^+ - \varphi_a^-)/TE - 0.5\gamma^{-1}\frac{\varphi_b^- - \varphi_a^-}{TR_b - TR_a} \qquad\qquad [4]$$

Equations [3] and [4] can again be used as input to calculate susceptibility $\chi$ and conductivity $\sigma$.

Susceptibility $\chi$ is related to $\Delta B_0$ via the unit dipole field kernel $d$ as described by the equation:

$$\Delta B_0 = B_0\, d \otimes \chi \qquad\qquad [5]$$

which can be solved for the unknown $\chi$ by using the computational technique described in Wang Y, Liu T, "Quantitative Susceptibility Mapping (QSM): Decoding MRI Data for a Tissue Magnetic Biomarker" Magnetic Resonance in Medicine 73:82-101(2015), which is hereby incorporated by reference in its entirety.

Conductivity $\sigma$ is related to $\varphi_1$ as described by the (truncated) Helmholtz equation:

$$\sigma = (\Delta\varphi_1)/(2\omega\mu_0) \qquad\qquad [6]$$

wherein $\Delta$ is the Laplace operator, $\omega$ is the Larmor frequency of the MR system used, and $\mu_0$ is the vacuum permeability. The electrical properties such as conductivity and permittivity (in case that not only $B_1$ phase, but also $B_1$ magnitude is provided) can be derived by using the computational technique disclosed in Katscher U, van den Berg CAT, "Electric properties tomography: Biochemical, physical and technical background, evaluation and clinical applications", NMR Biomed. 2017; e3729; https://doi.org/10.1002/nbm.3729, which is hereby incorporated by reference in its entirety.

Since both, the phase map and the tissue contrast can be derived from a single scan by using one of the MESS sequences for acquiring the magnetic resonance imaging data, besides the conductivity and susceptibility it is possible to derive the boundaries between different tissue types. Therefore, no error-prone registering of the image data of two or more independent scans is necessary for obtaining the different contrasts indicative for properties of anatomical tissue. Potential patient movement between the separate sequences requires registration of the different images, which is critical, particularly in case where diagnosis of joints of patent are involved. In oncology, for example, well co-localized imaging information is highly desirable. An additional advantage of deriving multiple tissue contrasts from single scan is that potentially no contrast agent needs to be administered to the patient for obtaining the various data.

The calculation of both, $\chi$ and $\sigma$, may benefit from a-priori knowledge of tissue boundaries conform the techniques used in Wang Y, Liu T, "Quantitative Susceptibility Mapping (QSM): Decoding MRI Data for a Tissue Magnetic Biomarker" Magnetic Resonance in Medicine 73:82-101(2015) and/or Katscher U, van den Berg CAT, "Electric properties tomography: Biochemical, physical and technical background, evaluation and clinical applications", NMR Biomed. 2017; e3729, hereby incorporated by reference in their entirety, which tissue boundaries can be extracted from the signal magnitude of one of the echoes. As the echo at $TE^+$ typically shows a higher SNR than the other echo(s), it is recommended to use this echo for tissue boundary extraction.

Tissue boundary determination can be improved by taking multiple magnitude images into account. For example, an edge detection algorithm, like the known Sobel or Canny algorithm, can be used and the results can be combined by straight-forward superposition or by locally weighted averaging.

In a further preferred embodiment, the step of deriving tissue boundaries involves a segmentation of the magnitude image (or multiple magnitude images). A known segmentation technique may be employed, such as, e.g. deep learning (DL) based image segmentation, preferably using (regional) convolutional neuronal networks (CNN). Segmentation is the process of partitioning the magnitude image(s) into multiple regions that share similar attributes, thus yielding the boundaries between different tissue types (healthy tissue vs. suspicious/cancerous tissue). Image segmentation has recently become the biggest target for DL approaches in medical imaging. MR image segmentation using DL, typically CNNs, has been proposed in almost the whole field of applications, whereof breast and brain tumor segmentation are only examples.

Diffusion sensitivity may be induced in the multi-echo steady-state imaging sequence by adding diffusion weighting magnetic field gradients. By using a strong diffusion gradient moment in the steady-state sequence, the resulting diffusion weighting highlights tumors with positive contrast as areas of restricted diffusion and thus enables to distinguish tumor and ductal tissue (see Granlund K.L. et al., "High-resolution, three-dimensional diffusion-weighted breast imaging using DESS", Magn. Reson. Imaging., 2014, 32, 330-341, hereby incorporated by reference in its entirety). DESS generates two echo signals between successive RF pulses, namely a Free Induction Decay (FID) signal and an echo signal from the steady-state free precession of the magnetization individually in each repetition. Phase encoding magnetic field gradients are balanced to maintain the steady-state of transverse magnetization. The collection of two signals (FID and echo signals) provides a means to correct for relaxation weighting and further provides the diffusion weighting and, thus, excellent tumor contrast in the magnitude image such that lesions can be detected and boundaries between normal and suspicious tissues can be derived, which may be in an optional embodiment a prerequisite for phase-based conductivity imaging and/or susceptibility imaging.

The phase map is suitable for EPT if it only relates to $B_1$, and it is not influenced by inhomogeneity of the main magnetic field $B_0$. Conventionally, any unwanted influence of $B_0$ inhomogeneity is avoided by using spin-echo based imaging sequences. The invention exploits that unwanted $B_0$ inhomogeneity influences on the phase map are negligible in steady-state acquisitions, because the phase remains almost unchanged for off-resonances within the pass band (frequency range corresponding to 1/TR). In a Diffusion Weighted DESS (DW-DESS) acquisition, e.g., the Bi-related phase map can directly be derived for each position in a reconstructed complex MR image from the real and imaginary parts of the respective image value. The same holds in principle for other multi-echo steady-state imaging sequences, like, e.g., TESS (see Kraff O. et al., "7 Tesla quantitative hip MRI: a comparison between TESS and CPMG for T2 mapping", Magnetic Resonance Materials in Physics, Biology and Medicine, 2016, 29(3), 503-512, which is hereby incorporated by reference in its entirety).

In one embodiment, two or more complex MR images are reconstructed such that each of the complex MR images is associated with one echo time value, i.e. one subset of echoes of the multi-echo steady-state imaging sequence. In the case of a DESS imaging sequence, two MR images are obtained from the two echoes generated in each interval between two successive RF pulses (or three MR images in the case of a TESS imaging sequence). A magnitude image and a phase map can then be derived from each complex MR image. In all cases, the MR images associated with the different echoes yield in principle the same phase map, but, of course, the magnitude images differ in their contrast. This can be utilized for reconstructing the electric conductivity map. Preferably, independent conductivity maps are calculated from the different sets of magnitude images and phase maps, and the conductivity maps are then combined into a final conductivity map, either by simple superposition (to obtain an average conductivity map as the final result) or by weighted averaging taking the signal-to-noise-ratio (SNR) into account such that the conductivity is taken at each image position with the largest SNR at the respective position.

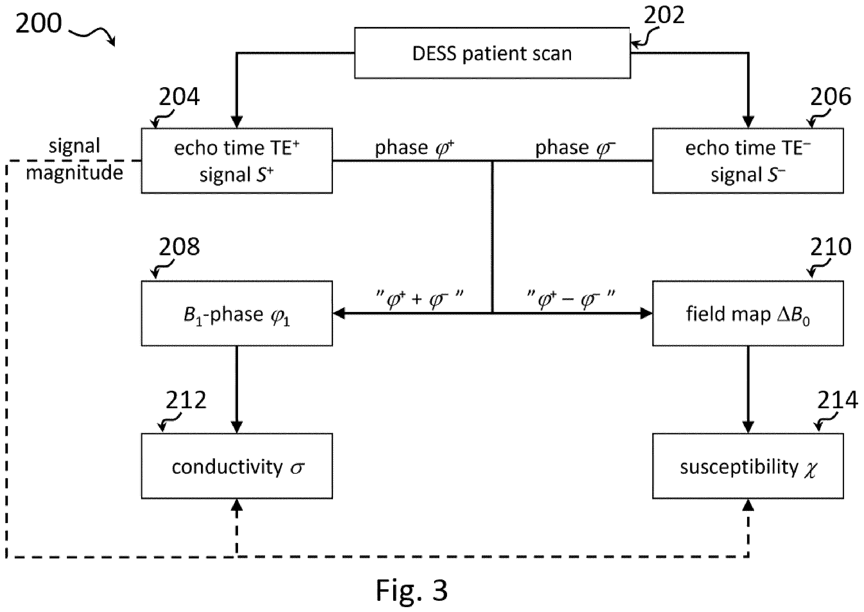

As disclosed in various embodiments according to the invention, the MESS sequence, e.g., DESS sequence, can either comprise diffusion weighting gradients in the sequence or not, depending on the number of biomarkers to be assessed by the medical personnel. Accordingly, referring to Fig. 2, in step 104 conductivity can be derived from the magnetic resonance imaging data besides susceptibility information as illustrated with the exemplary computation flowchart 200 in Fig. 3. The magnetic resonance data is provided by e.g., a patient scan 202 using a DESS imaging sequence, from which two complex images 204 and 206 can be derived based on the two different echoes. From the phase maps of these echoes, the $B_1$-phase $\varphi_1$ 208 as well as the field map $\Delta B_0$ 210 can be obtained, essentially based on adding or subtracting the two phase maps, respectively. Conductivity 212 and/or susceptibility 214 are then derived based on $\varphi_1$ and $\Delta B_0$. In optional embodiments, as already disclosed hereinbefore, deriving either one of susceptibility and conductivity may benefit from taking tissue boundaries into account, which information can be extracted from $S^+$ and is illustrated by the dashed line in Fig. 3.

Accordingly, for studies where only the T2 weighting, susceptibility and conductivity is regarded important, by skipping the diffusion weighting gradients in the sequence, two advantages can be obtained: TR gets shorter, and so does the total acquisition time, whereas also the SNR of the second echo increases, which is particularly valuable for the arithmetic of the phase maps required to derive susceptibility and conductivity as described above. In some embodiments, optionally, tissue boundary can be delimited based on signal magnitude $S^+$, as illustrated in Fig. 3.

In clinical cases with increased complexity, all potential biomarkers that can be obtained from a single scan may be particularly valuable for assessment of anomalies. In oncology, for example, well co-localized imaging information is highly desirable, such as T2 relaxation supporting localization of tumor tissue, diffusion being indicative of tumor microstructure/cellularity, susceptibility being indicative of tumor hemorrhage or micro-hemorrhage, and electrical properties such as conductivity being indicative of tumor malignancy via cell membrane effects and sodium content. In some embodiments, optionally, tissue boundary can be delimited based on signal magnitude $S^+$, whereas in other embodiments, the boundaries between normal and suspicious tissues may be derived based on diffusion weighting in the at least one magnitude image.

In order to suppress signal contributions from fat in applications like breast cancer diagnosis, the steady-state sequence is preferably performed with additional fat suppression, e.g., by employing spectrally selective RF pulses (water only excitation).

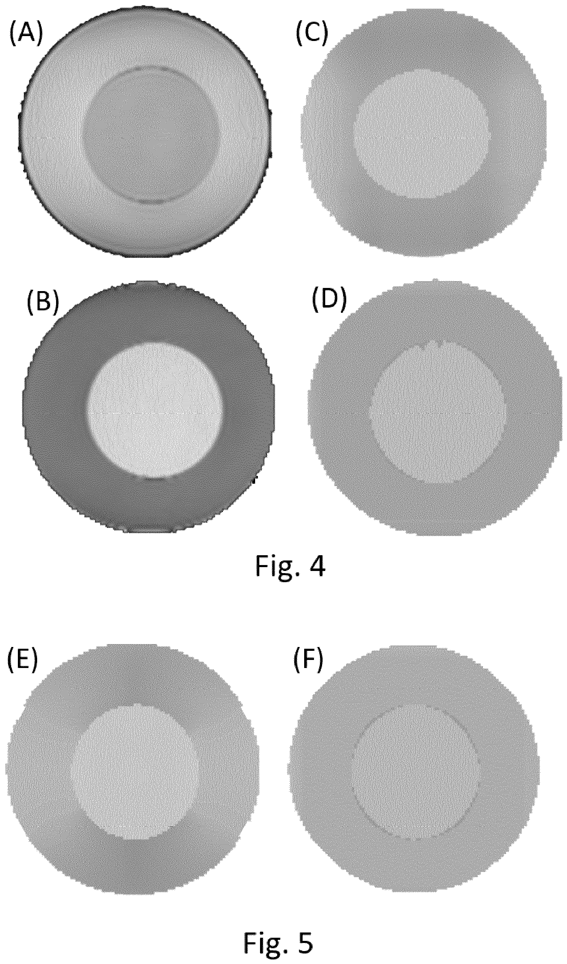

Experiments performed on a phantom comprising an inner compartment with a composition of 1.5 mg zinc + 1 g sodium / liter $H_2O$ and an outer compartment with a composition of 0.1 g sodium / liter $H_2O$ illustrate the feasibility of the method according to the invention. A DESS sequence was used for acquiring the magnetic resonance imaging data, with the following scan parameters: acquisition voxel of 2x2x4 mm$^3$; field of view of 180x180x120 mm$^3$; number of signal averages of 4; scan time of about 4 min; TRITE of 26/4.1 ms; flip angle of 25°; coronal slices. Fig. 4 illustrates the results, wherein (A) is the T2-weighted image, (B) is the diffusion weighted image, (C) is the susceptibility image and (D) is the conductivity image. The same phantom has been imaged with other acquisition sequences for comparison of the various images obtained by using the DESS acquisition sequence. Fig. 5 illustrates susceptibility image in (E) for an acquisition according to a multi-echo Fast Field Echo (mFFE) sequence, for which the duration of the data acquisition was about three minutes. Good correlation of the susceptibility images can be observed by comparison of Fig. 4 (C) with Fig. 5 (E). Similarly, a comparison of the conductivity images in Fig. 4 (D) and Fig. 5 (F) shows good correlation between the conductivity image derived from the acquisition according to the DESS sequence and the conductivity image derived from an acquisition according to balanced Fast Field Echo (bFFE) with an acquisition duration of about two minutes.

Accordingly, the invention provides various image contrasts that can be derived time-efficiently from a single scan, such as for example susceptibility with a combination of any of the T2 weighted image, diffusion weighted image and conductivity, all representing various biomarkers of which combination can lead to distinguishing different types of diseases and/or evolution of a specific type of disease (e.g., cancer).

Referring to Fig. 2, in step 106 of the method one or multiple images may be output to a display based on the susceptibility information. In optional embodiment the susceptibility information results may be overlayed on any other magnetic resonance image generated from the magnetic resonance imaging data, for example the anatomic image based on T2 weighted image. Colorbars may be output corresponding to the scales of values of properties presented in the generated image or multiple images.

The method of the invention described thus far can be carried out by means of an MR system or device, e.g., illustrated in Fig. 1, including at least one main magnet coil for generating a uniform static magnetic field within an examination volume, a number of gradient coils for generating switched magnetic field gradients in different spatial directions within the examination volume, at least one RF coil for generating RF pulses within the examination volume and/or for receiving MR signals from an object positioned in the examination volume, a control unit for controlling the temporal succession of RF pulses and switched magnetic field gradients, and a reconstruction unit. The method of the invention can be implemented, for example, by a corresponding programming.

It is understood that one or more of the aforementioned embodiments of the invention may be combined as long as the combined embodiments are not mutually exclusive.

As will be appreciated by one skilled in the art, aspects of the present invention may be embodied as a system, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a magnetic hard disk drive, a solid state hard disk, flash memory, a USB thumb drive, Random Access Memory (RAM), Read Only Memory (ROM), an optical disk, a magneto-optical disk, and the register file of the computational system. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further understood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen.

All directional references e.g., upper, lower, inner, outer, upward, downward, left, right, lateral, front, back, top, bottom, above, below, vertical, horizontal, clockwise, counterclockwise, proximal, and distal are only used for identification purposes to aid the reader's understanding of the claimed subject matter, and do not create limitations, particularly as to the position, orientation, or use of the reinforced multi-filar conductor bundle. Connection references, e.g., attached, coupled, connected, and joined are to be construed broadly and may include intermediate members between a collection of elements and relative movement between elements unless otherwise indicated. As such, connection references do not necessarily imply that two elements are directly connected and in fixed relation to each other. The term "or" shall be interpreted to mean "and/or" rather than "exclusive or." The word "comprising" does not exclude other elements or steps, and the indefinite article "a" or "an" does not exclude a plurality. Unless otherwise noted in the claims, stated values shall be interpreted as illustrative only and shall not be taken to be limiting.

Although various embodiments of the claimed subject matter have been described above with a certain degree of particularity, or with reference to one or more individual embodiments, those skilled in the art could make numerous alterations to the disclosed embodiments without departing from the spirit or scope of the claimed subject matter.

Still other embodiments are contemplated. It is intended that all matter contained in the above description and shown in the accompanying drawings shall be interpreted as illustrative only of particular embodiments and not limiting. Changes in detail or structure may be made without departing from the basic elements of the subject matter as defined in the following claims.

**Claims**

1. A method (100) of magnetic resonance imaging, comprising:

   receiving magnetic resonance imaging data (102), wherein at least a portion of a body (10) is subjected to a steady-state imaging sequence that samples multiple coherence pathways, wherein two or more echo signals are generated in each interval between successive radiofrequency pulses;
   deriving susceptibility information (104, 214) from the magnetic resonance imaging data;
   outputting to a display an image (C) based on the susceptibility information.

2. The method of claim 1, further comprising:

   deriving conductivity information (212) from the magnetic resonance imaging data;
   outputting to the display an image (D) based on the conductivity information.

**3.** The method of claim 1 or 2, further comprising:

deriving T2 weighted information from the magnetic resonance imaging data;
outputting to the display an image (A) based on the T2 weighted information.

**4.** The method of any of the preceding claims, wherein the steady-state imaging sequence comprises diffusion sensitizing gradients, and wherein the method further comprises:

deriving diffusion weighted information from the magnetic resonance imaging data;
outputting to the display an image (B) based on the diffusion weighted information.

**5.** The method of any of the preceding claims, wherein tissue boundaries are derived based on signal magnitude of one of the multiple echoes.

**6.** The method of claim 5, wherein the first echo is used for tissue boundary detection.

**7.** The method of claim 5 or 6, wherein deriving tissue boundaries involves a segmentation of a magnitude image.

**8.** The method of claim 7, wherein the segmentation of the magnitude image is based on deep learning.

**9.** The method of any of the claims 5 to 8, wherein deriving tissue boundaries is a prerequisite of deriving susceptibility information.

**10.** The method of any of the preceding claims, wherein the steady-state imaging sequence is a double-echo steady-state sequence.

**11.** The method of any of the preceding claims, wherein deriving susceptibility information is preceded by providing anatomical segmentation of the imaged portion of the body into one or more anatomical regions.

**12.** The method of claim 11, wherein outputting the image comprises replacing each of the segmented one or more anatomical regions with corresponding susceptibility information.

**13.** The method of claim 11, wherein outputting the image comprises overlaying susceptibility information on the respective one or more anatomical regions on an anatomic image, wherein the anatomic image is preferably the magnetic resonance image used for providing the image segmentation.

**14.** A system (1) for magnetic resonance imaging, comprising:

- a processor (17) configured to perform a method according to any of the claims 1 to 13.

**15.** A computer program comprising machine executable instructions, wherein execution of the machine executable instructions causes a computational system to perform a method according to any of the claims 1 to 13.

Fig. 1

Fig. 2

Fig. 3

EP 4 575 541 A1

(A)

(C)

(B)

(D)

Fig. 4

(E)

(F)

Fig. 5

EP 4 575 541 A1

**Application Number**

EP 23 21 8953

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | M-L. WU ET AL: "Midbrain nuclei visualization improved by susceptibility-enhanced 3D multi-echo SSFP for deep brain stimulation guidance", PROCEEDINGS OF THE INTERNATIONAL SOCIETY FOR MAGNETIC RESONANCE IN MEDICINE, 18TH SCIENTIFIC MEETING AND EXHIBITION, STOCKHOLM, SWEDEN, 1-7 MAY 2010, vol. 18, 17 April 2010 (2010-04-17), page 701, XP040617040, | 1,14,15 | INV.<br>G01R33/44<br>G01R33/561<br><br>ADD.<br>G01R33/50<br>G01R33/54<br>G01R33/56<br>G01R33/563 |
| A | * paragraph [0001] - paragraph [0002]; figure 1 * | 2,10 | |
| X | WU MING-LONG ET AL: "Efficient imaging of midbrain nuclei using inverse double-echo steady-state acquisitiona)", MEDICAL PHYSICS, AIP, MELVILLE, NY, US, vol. 42, no. 7, 26 June 2015 (2015-06-26), pages 4367-4374, XP012198622, ISSN: 0094-2405, DOI: 10.1118/1.4922402 [retrieved on 1901-01-01] | 1,10,14, 15 | |
| A | * section 2; page 4368 - page 4369; figures 1, 6 * | 2 | TECHNICAL FIELDS SEARCHED (IPC)<br><br>G01R |
| X | JONG-MIN KIM ET AL: "Monitoring and Guidance on High-Intensity Focused Ultrasound Treatment by Multiple Fast Field Echo at 3.0 T MRI: Ex-Vivo Studies with Multiparametric Mapping", PROCEEDINGS OF THE INTERNATIONAL SOCIETY FOR MAGNETIC RESONANCE IN MEDICINE, 26TH ANNUAL MEETING AND EXHIBITION, PARIS, FRANCE, 16-21 JUNE 2018, vol. 26, 1485, 1 June 2018 (2018-06-01), XP040700693, | 1,2,14, 15 | |
| A | * page 1; figures 1, 4 * | 10 | |

-/--

The present search report has been drawn up for all claims

| Place of search | Date of completion of the search | Examiner |
|---|---|---|
| Munich | 15 May 2024 | Raguin, Guy |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches
Patentamt

European
Patent Office

Office européen
des brevets

**EUROPEAN SEARCH REPORT**

Application Number

EP 23 21 8953

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HAN-JAE CHUNG ET AL: "Electro-Magnetic Property Mapping Using Kalman Filtering with a Single Acquistion at 3.0 T and 7.0 T MRI", PROCEEDINGS OF THE INTERNATIONAL SOCIETY FOR MAGNETIC RESONANCE IN MEDICINE, 26TH ANNUAL MEETING AND EXHIBITION, PARIS, FRANCE, 16-21 JUNE 2018, vol. 26, 5081, 1 June 2018 (2018-06-01), XP040704289, | 1,2,14, 15 | |
| A | * page 1; figures 1, 2, 3 *<br>----- | 10 | |
| | | | TECHNICAL FIELDS SEARCHED (IPC) |

~~The present search report has been drawn up for all claims~~

| Place of search | Date of completion of the search | Examiner |
|---|---|---|
| Munich | 15 May 2024 | Raguin, Guy |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

......................................................................
& : member of the same patent family, corresponding
document

EPO FORM 1503 03.82 (P04C01)

page 2 of 2

Europäisches
Patentamt

European
Patent Office

Office européen
des brevets

**Application Number**

EP 23 21 8953

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

1, 2, 10(completely); 14, 15(partially)

☐ The present supplementary European search report has been drawn up for those parts of the European patent application which relate to the invention first mentioned in the claims (Rule 164 (1) EPC).

16

Europäisches
Patentamt

European
Patent Office

Office européen
des brevets

**LACK OF UNITY OF INVENTION
SHEET B**

Application Number

EP 23 21 8953

The Search Division considers that the present European patent application does not comply with the requirements of unity of invention and relates to several inventions or groups of inventions, namely:

1. claims: 1, 2, 10(completely); 14, 15(partially)

Method, system and computer program for magnetic resonance imaging, comprising receiving magnetic resonance imaging data, wherein at least a portion of a body is subjected to a steady-state imaging sequence that samples multiple coherence pathways, wherein two or more echo signals are generated in each interval between successive radiofrequency pulses; deriving susceptibility information from the magnetic resonance imaging data; outputting to a display an image based on the susceptibility information; and further comprising deriving conductivity information from the magnetic resonance imaging data and outputting to the display an image based on the conductivity information.

- - -

2. claims: 3(completely); 14, 15(partially)

Method, system and computer program for magnetic resonance imaging, comprising receiving magnetic resonance imaging data, wherein at least a portion of a body is subjected to a steady-state imaging sequence that samples multiple coherence pathways, wherein two or more echo signals are generated in each interval between successive radiofrequency pulses; deriving susceptibility information from the magnetic resonance imaging data; outputting to a display an image based on the susceptibility information; and further comprising deriving T2 weighted information from the magnetic resonance imaging data; and outputting to the display an image based on the T2 weighted information.

- - -

3. claims: 4(completely); 14, 15(partially)

Method, system and computer program for magnetic resonance imaging, comprising receiving magnetic resonance imaging data, wherein at least a portion of a body is subjected to a steady-state imaging sequence that samples multiple coherence pathways, wherein two or more echo signals are generated in each interval between successive radiofrequency pulses; deriving susceptibility information from the magnetic resonance imaging data; outputting to a display an image based on the susceptibility information; wherein the steady-state imaging sequence further comprises diffusion sensitizing gradients; and further comprising deriving diffusion weighted information from the magnetic resonance imaging data; and outputting to the display an image based on the diffusion weighted information.

- - -

4. claims: 5-9, 11-13(completely); 14, 15(partially)

Europäisches
Patentamt

European
Patent Office

Office européen
des brevets

**LACK OF UNITY OF INVENTION
SHEET B**

**Application Number**

EP 23 21 8953

The Search Division considers that the present European patent application does not comply with the requirements of unity of invention and relates to several inventions or groups of inventions, namely:

Method, system and computer program for magnetic resonance imaging, comprising receiving magnetic resonance imaging data, wherein at least a portion of a body is subjected to a steady-state imaging sequence that samples multiple coherence pathways, wherein two or more echo signals are generated in each interval between successive radiofrequency pulses; deriving susceptibility information from the magnetic resonance imaging data; outputting to a display an image based on the susceptibility information; wherein tissue boundaries are derived based on signal magnitude of one of the multiple echoes.

- - -

page 2 of 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020254571 A1

**Non-patent literature cited in the description**

- **LEIJSEN R. et al.** Electrical Properties Tomography: A Methodological Review. *Diagnostics*, 2021, vol. 11, 176, https://doi.org/10.3390/diagnostics11020176
- **WANG Y ; LIU T**. Quantitative Susceptibility Mapping (QSM): Decoding MRI Data for a Tissue Magnetic Biomarker. *Magnetic Resonance in Medicine*, 2015, vol. 73, 82-101
- **KATSCHER U ; VAN DEN BERG CAT**. Electric properties tomography: Biochemical, physical and technical background, evaluation and clinical applications. *NMR Biomed*, 2017, e3729, https://doi.org/10.1002/nbm.3729

- **KATSCHER U ; VAN DEN BERG CAT**. Electric properties tomography: Biochemical, physical and technical background, evaluation and clinical applications. *NMR Biomed.*, 2017, e3729
- **GRANLUND K.L. et al.** High-resolution, three-dimensional diffusion-weighted breast imaging using DESS. *Magn. Reson. Imaging.*, 2014, vol. 32, 330-341
- **KRAFF O et al.** 7 Tesla quantitative hip MRI: a comparison between TESS and CPMG for T2 mapping. *Magnetic Resonance Materials in Physics, Biology and Medicine*, 2016, vol. 29 (3), 503-512